Europäisches Patentamt

European Patent Office

Office européen des brevets

(11) Publication number: **0 325 350**
**A2**

# EUROPEAN PATENT APPLICATION

(21) Application number: **89300149.5**

(51) Int. Cl.⁴: **G01R 15/07**

(22) Date of filing: **09.01.89**

(30) Priority: **19.01.88 GB 8801082**

(43) Date of publication of application:
**26.07.89 Bulletin 89/30**

(84) Designated Contracting States:
**DE FR GB IT**

(71) Applicant: **THORN EMI plc**
**4 Tenterden Street**
**London W1A 2AY(GB)**

(72) Inventor: **Bell, Edward Charles**
**1, Poolmans Court Poolmans Road**
**Windsor Berkshire, SL4 4NZ(GB)**

(74) Representative: **Marsh, Robin Geoffrey et al**
**Thorn EMI Patents Limited The Quadrangle**
**Westmount Centre Uxbridge Road**
**Hayes Middlesex, UB4 0HB(GB)**

(54) Sensing device.

(57) A sensing device (1) for sensing a stimulus and transmitting a signal from a test location to a remote location, the device comprising: means (3) for generating an a.c. signal; a sensing element (2) responsive to said test location stimulus, the response of the sensing element (2) being such as to modulate the frequency of the a.c. signal; electro-optic modulator means (4) receptive of incoming optical energy and responsive to the frequency modulated output signal of the a.c. generating means (3) for converting the incoming optical energy into a modulated optical signal, the electro-optic modulator means (4) being operable on frequency modulated signals with a power of $10\mu Wcm^{-2}$ or less of modulator surface. The use of a low power electro-optic sensor, such as a liquid crystal modulator makes the device of the invention particularly suitable for reading miniature micro-engineered sensing elements mulitplexed on Fibre Optic Wavelength Multiplexed sensor systems where the optical power available for each sensor is low.

FIG.1

## SENSING DEVICE

This invention relates to a sensing device and, more particularly, to an electro-optical sensing device of the kind used to detect a stimulus at a test location and transmit an optical signal from the test location to a remote location for analysis.

Such devices commonly comprise a sensing means for sensing stimuli and generating an electrical signal therefrom, to drive an optical modulator which modulates an incoming light beam, into an optical signal. The modulated optical signal is normally transmitted from the test location to a remote location, by means of an optical fibre, for analysis. It is common in such devices to use part of the incoming light beam as an energy source for operating the optical modulator and the sensing means.

A device of this kind is disclosed in British Patent Specification GB 2 117 993 which discloses the use of intensity modulation of an optical signal. However, if such a device is used in wavelength multiplexed systems 'cross-talk' problems arise. United States Patent Specification US 4525873 discloses a sensing device which uses frequency modulation of the optical modulator. However, the type of modulator used in this device requires an optical source of relatively high power.

It is therefore an object of the present invention to provide an electro-optical sensing device which alleviates the above disadvantages of known devices.

According to the present invention there is provided a sensing device for sensing a stimulus and transmitting a signal from a test location to a remote location, the device comprising: means for generating an a.c. signal; a sensing element responsive to said test location stimulus, the response to the sensing element being such as to modulate the frequency of the said a.c. signal; electro-optic modulator means receptive of incoming optical energy and responsive to the frequency modulated output signal of the a.c. generating means for converting the incoming optical energy into a modulated optical signal, the electro-optic modulator means being operable on frequency modulated signals with a power of $10\mu Wcm^{-2}$ or less of modulator surface.

Preferably, in one embodiment of the invention the electro-optic modulator means is a liquid crystal device.

Preferably, in another embodiment of the invention the electro-optic modulator means is an electrocapilliarity device.

Preferably, in yet another embodiment of the invention the electro-optic modulator means is a microshutter device.

Preferably, the sensing device further comprises a source of optical energy at a remote location for coupling to the electro-optic modulator means.

Preferably, the sensing device further comprises an optical line to effect the coupling of the source of optical energy at the remote location to the electro-optic modulator means and thus for transmitting the optical energy to the modulator means.

Preferably, the said optical line also acts as the output means for transmitting the frequency-modulated optical signal to the remote location.

Preferably, the sensing device further comprises means for converting some of the incoming optical energy into electrical energy for operation of the a.c. signal generating means and the electro-optic modulator.

Preferably, the sensing element of the sensing device is responsive to mechanical energy.

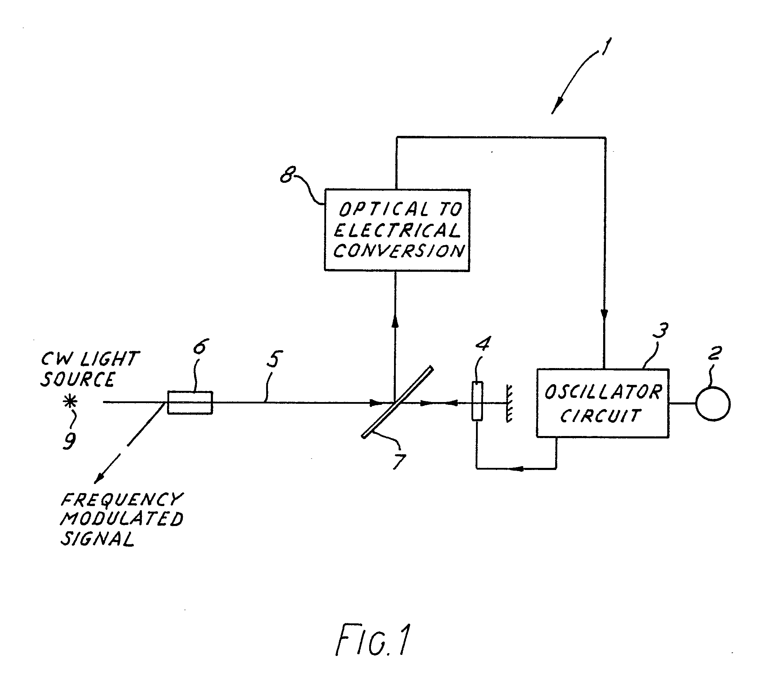

A preferred embodiment of the invention will now be described by way of example only and with reference to accompanying drawings of Figure 1, which is a schematic diagram of a device embodying the invention.

A sensing device shown generally at 1 is intended for use in a multiplexed system comprises a capacitive sensing element 2, an oscillator circuit 3, a liquid crystal optical modulator 4, an optical fibre 5 in a multiplexed arrangement and a coupler 6. The device additionally comprises a beam splitter 7 and an optical to electrical converter 8. A remote carrier wave light source 9 provides the source of optical energy for the device.

The variable-capacitance sensing element 2, which in this instance is a mechanical sensing element, tests the condition to be measured.

As the capacitance of the sensing element 2 changes, due to changing stimulus, it modulates the frequency of the oscillator circuit 3. A suitable sensing element 2 is a silicon cantilevered mechanism which undergoes a change in capacitance between a contact on one end of the beam and earth as the beam is deflected by a mechanical force.

This frequency-modulated signal generated by the oscillator circuit 3 is then used to drive the liquid crystal optical modulator 4 which then modulates an incoming light beam transmitted to it by the optical fibre 5 from the carrier wave light source 9. The resulting frequency-modulated optical signal is then fed back along the fibre and recovered by means of the coupler 6. The signal so recovered is proportional to the measurement acting on the sensing element 2.

The beam splitter 7 ensures that part of the incoming light beam, transmitted along the optical fibre 5, is diverted to the optical to electrical converter 8 which converts the optical energy into electrical power to drive the oscillator circuit 3 and optical modulator 4. The beam splitter 7 would be a fibre or waveguide directional coupler.

An advantage of the device of the invention is that the use of a frequency modulated electrical signal to drive a liquid crystal optical modulator ensures that the optical power necessary to power the sensor is very low, since the power required to operate a liquid crystal modulator is typically 1 $\mu$W per square centimetre of modulator surface. This makes the device of the invention particularly suitable for reading miniature micro-engineered sensing elements multiplexed on Fibre Optic Wavelength Multiplexed sensor systems where the optical power avaialble for each sensor is low, typically 350 nanowatts. Such multiplexed systems are also likely to suffer from power fluctuations and optical cross-talk between sensors. The particular use of a frequency modulated electrical signal in the sensing device helps to substantially alleviate these problems.

An additional advantage of a low power operating liquid crystal optical modulator is that it may be powered by a small battery at the test location thus overcoming the need for an optical-electrical convertor at the test location. Since none of the incoming optical energy is being diverted away with such an arrangement, operation of the sensor at even lower optical power levels is possible.

A suitable battery for this purpose is the type of battery used to power watches which may have an operational life of 5 years.

If preferred, an electrocapilliarity device can be used as the optical modulator, instead of the liquid crystal device. Such devices typically require operating powers of 1 $\mu$W per square centimetre of modulator surface.

Alternatively, a micro-shutter device can be used as the optical modulator. Such devices typically requiring operating powers of 1nW per square centimetre of modulator surface.

modulated output signal of the a.c. generating means for converting the incoming optical energy into a modulated optical signal, the electro-optic modulator means being operable on frequency modulated signals with a power of 10 $\mu$Wcm$^{-2}$ or less of modulator surface.

2. A sensing device according to Claim 1 wherein the electro-optic modulator means is a liquid crystal device.

3. A sensing device according to Claim 1, wherein the electro-optic modulator means is an electrocapilliarity device.

4. A sensing device according to Claim 1 wherein the electro-optic modulator means is a microshutter device.

5. A sensing device according to any one of the preceding claims, wherein said device comprises a source of optical energy at a remote location for coupling to the electro-optic modulator means.

6. A sensing device according to Claim 5 wherein said device comprises an optical line to effect the coupling of the source of optical energy at the remote location to the electro-optic modulator means and thus for transmitting the optical energy to the modulator means.

7. A sensing device according to Claim 6, wherein the optical line also acts as the output means for transmitting the frequency-modulated optical signal to the remote location.

8. A sensing device according to Claim 1, wherein said device comprises means for converting some of the incoming energy into electrical energy for operation of the a.c. signal generating means and the electro-optic modulator.

9. A sensing device according to Claim 1 wherein the sensing element of the sensing device is responsive to mechanical energy.

## Claims

1. A sensing device for sensing a stimulus and transmitting a signal from a test location to a remote location, the device comprising means for generating an a.c. signal; a sensing element responsive to said test location stimulus, the response of the sensing element being such as to modulate the frequency of the said a.c. signal; electro-optic modulator means receptive of incoming optical energy and responsive to the frequency

*8*

OPTICAL TO
ELECTRICAL
CONVERSION

*1*

*3*

OSCILLATOR
CIRCUIT

*2*

CW LIGHT
SOURCE
*

*6*

*5*

*4*

*7*

*9*

FREQUENCY
MODULATED
SIGNAL

FIG.1